# EUROPEAN PATENT APPLICATION

(11) **EP 1 180 783 A2**
(43) Date of publication of application: **20.02.2002**
(21) Application number: 01306534.7
(22) Date of filing: 31.07.2001
(51) Int. Cl.: H01J 27/04, H01J 37/08

(54) **Magnet for generating a magnetic field in an ion source**

(30) Priority: 07.08.2000 US 633324
(71) Applicant: Axcelis Technologies, Inc., Beverly, MA 01915 (US)
(72) Inventor: Vanderberg, Bo Harald, Boston, Massachusetts 02108 (US); Horsky, Thomas Neil, Boxborough, Massachusetts 01719 (US); Trueira, Frank Raymond, York, Maine 03909 (US)
(74) Representative: Burke, Steven David

(57) **Abstract**

An ion source (10) for an ion implanter is provided, comprising (i) an ionization chamber (14) defined at least partially by chamber walls (12) and having an aperture (18) through which an ion beam (B) may be extracted along a path (P2); and (ii) a magnet assembly (45) entirely surrounding the ionization chamber (14), comprising a closed figure yoke (46) about which is wound a pair of coils (49, 51). The yoke (46) is preferably toroidal in shape and further comprises a pair of opposing poles (48a, 48b), wherein a substantial portion of magnetic flux (F) generated by the coils leaves a first of the opposing poles (48a), passes through the ionization chamber (14), and enters a second of the opposing poles (48b) during operation of the ion source. A non-magnetic shield (52) surrounds the magnet assembly (45) to shield the assembly from backstreaming electrons. Stray magnetic fields generated by the magnet assembly (45) are oriented in a direction perpendicular to and kept low within the path of an ion beam extracted from the aperture. The primary magnetic field output by the magnetic assembly (45) is relatively homogeneous within the ionization chamber (14).

## Description

### Related Application

The following U.S. patent application is incorporated by reference herein as if it had been fully set forth: Application Serial Number: 633,322, filed on 7 August, 2000, entitled Ion Source Having Replaceable and Sputterable Solid Source Material, (corresponding to EP Application No. ________, Agents ref. J00043574EP having a filing date coincident with that of the present application).

### Field of the Invention

The present invention relates generally to the field of semiconductor processing systems such as ion implanters, and more specifically to a magnet for generating a magnetic field in an ion source for use in such an ion implanter.

### Background of the Invention

In the large-scale manufacture of integrated circuits, ion implantation has become a standard accepted technology of industry to dope workpieces such as silicon wafers with impurities. Conventional ion implantation systems include an ion source that ionizes a desired dopant element which is then accelerated to form an ion beam of a prescribed energy. The ion beam is directed at the surface of the workpiece to implant the workpiece with the dopant element. The energetic ions of the ion beam penetrate the surface of the workpiece so that they are embedded into the crystalline lattice of the workpiece material to form a region of desired conductivity. The implantation process is typically performed in a high vacuum process chamber which prevents dispersion of the ion beam by collisions with residual gas molecules and which minimizes the risk of contamination of the workpiece by airborne particulates.

Ion dose and energy are the two most important variables used to define an implant step. Ion dose relates to the concentration of implanted ions for a given semiconductor material. Typically, high current implanters (generally capable of generating tens of milliamps (mA) of ion beam current are used for high dose implants, while medium current implanters (generally capable up to about 1 mA beam current) are used for lower dose applications. Ion energy is used to control junction depth in semiconductor devices. The energy levels of the ions that comprise the ion beam determine the degree of depth of the implanted ions. High energy processes such as those used to form retrograde wells in most semiconductor devices require implants of up to a few million electron volts (MeV), while shallow junctions may only demand energies below 1 thousand electron volts (keV).

Conventional ion sources utilize an ionizable dopant gas that is obtained either directly from a source of a compressed gas or indirectly from a solid from which has been vaporized. Typical source elements are boron (B), phosphorous (P), gallium (Ga), indium (In), antimony (Sb), and arsenic (As). These source elements can be provided in solid form or in gaseous form, such as boron, which may be provided in either solid form (B) or in gaseous form as boron trifluoride (BF₃).

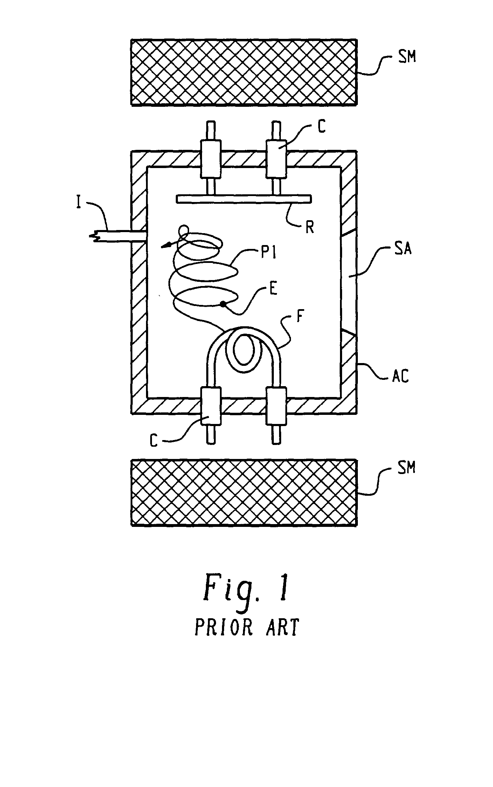

A typical ion source 10 for obtaining atoms for ionization from a solid or gaseous form is shown in Figure 1. This type of ion source comprises an arc chamber AC, which functions as an anode, and a filament F contained therein which functions as a cathode. In operation, an arc voltage is applied between the filament F and the walls of the arc chamber AC. The energized filament thermionically emits high-energy electrons E that are accelerated toward the electrically grounded (*i.e.,* relatively positively biased) chamber wall. A gas containing boron or phosphorous is fed into the arc chamber AC via an inlet I.

A repeller R is positioned within the arc chamber AC opposite the filament F. A ceramic insulator C insulates both the filament and the repeller from the walls of the arc chamber, which are typically maintained at ground potential. The repeller electrostatically repels the filament-emitted electrons E to confine these electrons to a path P1 within an ionization region between the filament and the repeller.

The electrons E collide with and dissociate and/or ionize the gas molecules in the ionization region, where the number of collisions with ionizable gas molecules is maximized. Positive ions are created when an electron is removed from the outer shell of these gas molecules by the filament-emitted electrons E. In this manner, a plasma is created comprised at least partially of positively charged ions. A generally positively charged ion beam is drawn from this plasma, typically through a source aperture SA in the arc chamber, by means of an electrode at negative bias (not shown).

In addition to the repeller R, a typical ion source also includes source magnets SM. The source magnets SM induce a magnetic field along the arc chamber AC. The magnetic field causes the path P1 of the electrons E emitted by the filament F to be helical, which further increases the yield of collisions with the gas molecules. The source magnet SM thereby increases ionization efficiency in the arc chamber . The source magnet current is adjusted by a power supply (not shown) to maximize the extracted ion beam current. Accordingly, both the source magnets SM and the repeller R function to confine the high-energy electrons emitted by the filament F to within the ionization region of the arc chamber.

The electron confinement efficiency at a given electron temperature increases with magnetic field strength, and gas ionization rates increase with the increasing electron temperature. It can therefore be desirable to induce strong magnetic fields in an ion source ionization chamber. However, the magnetic field outside the ionization chamber, and in particular within the ion beam path, should be kept low so that the ion implanter optics are not adversely affected. Finally, a homogeneous field in the center of the ionization chamber is desirable because low field gradients provide better confinement and more stable plasmas.

The use of a source magnet SM in such close proximity to the ionization chamber, however, introduces stray fields which adversely affect beam quality. Specifically, stray magnetic fields outside of the ionization chamber interfere with the emittance characteristics, because they are parallel to the ion beam path, extending into the area of the extraction electrode. Further, traditional source magnets provide non-homogeneous magnetic fields within the ionization chamber which leads to instabilities in ionization and electromagnetic noise.

Accordingly, it is an object of the present invention to provide a mechanism for creating and sustaining a strong and uniform magnetic field within an ion source ionization chamber, in order to permit highly efficient ionization rates. It is a further object of the present invention to provide such a mechanism wherein the magnetic field is induced and concentrated within the ionization chamber, It is still a further object of the invention to generate such a magnetic field while minimizing stray magnetic fields outside of the ionization chamber, thereby improving ion beam emittance characteristics.

### Summary of the Invention

An ion source for an ion implanter is provided, comprising (i) an ionization chamber defined at least partially by chamber walls and having an aperture through which an ion beam may be extracted along a path; and (ii) a magnet assembly entirely surrounding the ionization chamber, comprising a closed figure yoke about which is wound a pair of coils. The yoke is preferably toroidal in shape and further comprises a pair of opposing poles, wherein a substantial portion of magnetic flux generated by the coils leaves a first of the opposing poles, passes through the ionization chamber, and enters a second of the opposing poles during operation of the ion source. Stray magnetic fields generated by the magnet assembly are oriented in a direction perpendicular to and kept low within the path of an ion beam extracted from the aperture. The primary magnetic field output by the magnetic assembly is relatively homogeneous within the ionization chamber. The efficiency of the magnet assembly is thereby enhanced.

### Brief Description of the Drawings

Figure 1 is a sectional view of a conventional ion source;
Figure 2 is a sectional view of an ion source constructed according to the principles of the present invention;
Figure 3 is a front view of the ion source of Figure 2, taken along the lines 3-3; and
Figures 4 through 6 show various views of the magnetic field strength generated by the magnet assembly of the ion source, taken in three mutually orthogonal planes.

### Detailed Description of a Preferred Embodiment

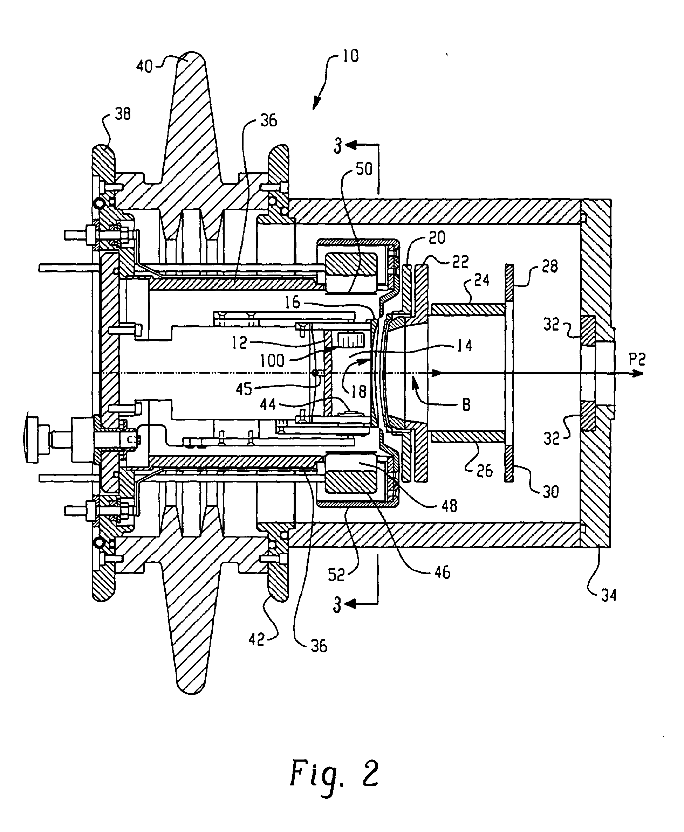

Referring now to the drawings, Figure 2 shows an ion source 10 for an ion implanter into which is incorporated the inventive repeller 100 of the present invention. The ion source 10 comprises chamber walls 12 that from an ionization chamber 14 in which a plasma is formed. A source aperture plate 16, having an aperture 18 formed therein, permits the ion beam B to be drawn out of the ionization chamber 14 by extraction electrodes 20 and 22 along a path P2.

The extraction electrodes are typically negatively biased with respect to the aperture plate 16 and the other ion source walls 12, so that the ion beam extracted from the ionization chamber is comprised primarily of positive ions. Aluminum support legs 24 and 26 support half rings 28 and 30, respectively, which guide the ion beam B through graphite inserts 32 in the source housing 34.

An ion source assembly support tube 36 surrounds and supports the ionization chamber and abuts a mounting flange 38. An insulator 40 electrically isolates the mounting flange 38 and a flange 42 on the source housing 34. The insulator 40 isolates the source housing 34 from the energization voltages required to generate ions in and accelerate ions away from the arc chamber 14.

Within the chamber walls 12 of the ionization chamber 14 resides a filament (not shown) at least partially contained within an indirectly heated cathode 44, at one end of the chamber, and the repeller 100, located at the other end, opposite the cathode. A gas such as argon (Ar) is injected into the ionization chamber 14 via inlet 45 and the filament is energized to thermionically emit electrons. These filament-emitted electrons accelerate toward and contact the indirectly heated cathode 44, which in turn emits electrons into the arc chamber 14. The repeller (or anticathode) 100, which resides at a negative electrical potential, as further explained below, repels the electrons back toward the indirectly heated cathode 44. The repeller 100 thereby functions to centrally confine these cathode-emitted electrons within the chamber, where they have the greatest number of collisions with and subsequent ionization of the gas molecules.

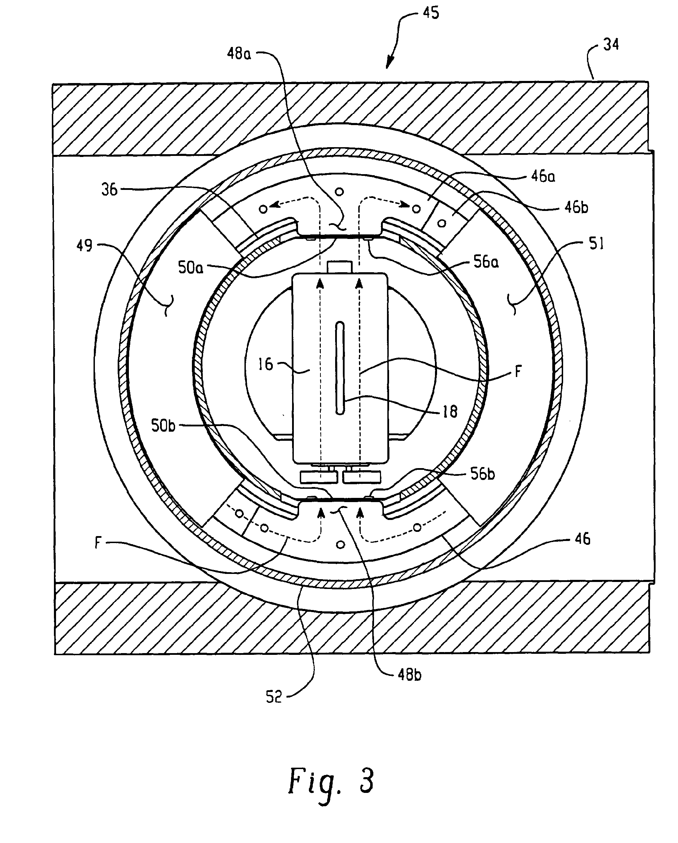

Circumferentially and entirely surrounding the ionization chamber is a magnet assembly 45, mounted to the source assembly support tube 36, comprising (i) a closed figure annular yoke 46 about which is wound a pair of coils 49 and 51 (see Figure 3), (ii) magnetic poles 48 which are diametrically opposed to each other and extend from the yoke 46, and (iii) heat shields 50 attached to each of the magnetic poles 48. A non-magnetic shield 52 surrounds the entire magnet assembly to shield the assembly from backstreaming electrons. The magnetic fields are thereby concentrated within the ionization chamber 14 to enhance plasma ionization rates.

The magnet assembly 45 is shown in greater detail in Figure 3. The annular (or toroidal) yoke is comprised of two iron pieces, 46a and 46b, attached together to form the ring about which coils 49 and 51 are wound. Pole 48a is formed as a portion of yoke half 46a, and pole 48b is formed as a portion of yoke half 46b. Heat shields 50a and 50b, protect poles 48a and 48b, respectively, from the heat generated in the ionization chamber 14. The heat shields 50a and 50b are fixed in place by fasteners 56a and 56b.

Electrical current is provided to the coils 49 and 51 in a manner well known in the art, enabling magnets to generate a magnetic flux through the closed loop structure of the annular yoke. Figure 3 shows the directions of the magnetic flux lines F generated by each of the coils. The coils 49 and 51 induce flux lines F in opposite directions with respect to the circumference of the annular yoke. The majority of the flux is guided by the toroidal yoke. Flux lines induced by the coils and leaving the pole 48b have a common return path through the ionization chamber 14 to the opposite pole 48a through the ionization chamber 14. A small fraction of the magnetic flux F returns outside of the toroid.

The coils also generate a leakage field from the coils through the vacuum in which the ion source and magnet assembly are located. Thus, the net magnetic field in the ionization chamber is the superposition of the return field from the yoke through the pole pieces and the leakage field from the coils through the vacuum.

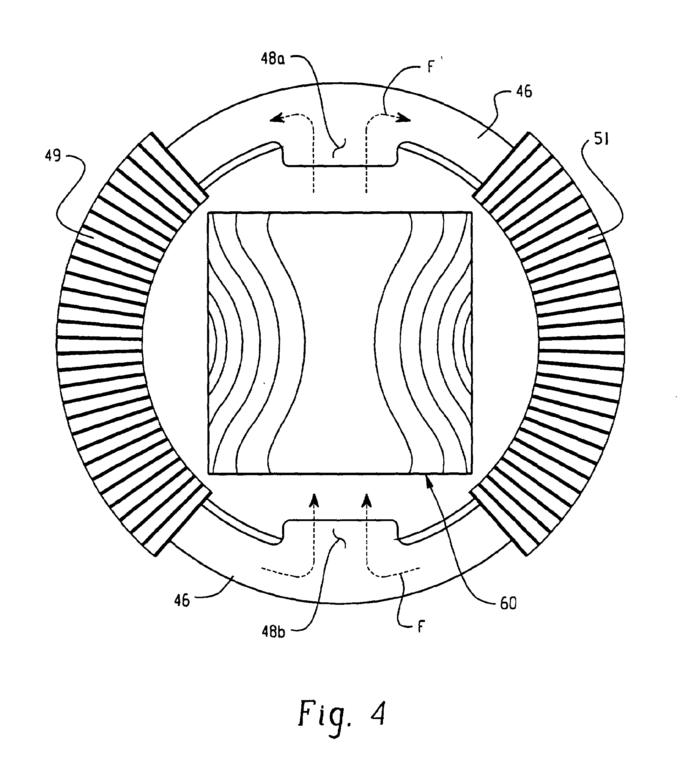

Figures 4 through 6 show various views of the magnetic field strength generated by the magnet assembly of the ion source, taken in three mutually orthogonal planes. Figure 4 shows the magnetic field strength in the plane of the yoke 46. As shown in Figure 4, the magnetic field strength is strongest near the coils, and having a steep gradient such that it is relatively homogeneous for a significant central portion 60 of the plane wherein the ionization chamber resides. The strength of the magnetic field in this central portion area 60 is for the coils on the order of 500 gauss for a magnetomotive force of 25 amps X 225 turns. The strength of the magnetic field is maximized by locating the coils 49 and 51 and the yoke 46 in close proximity to the ionization chamber 14.

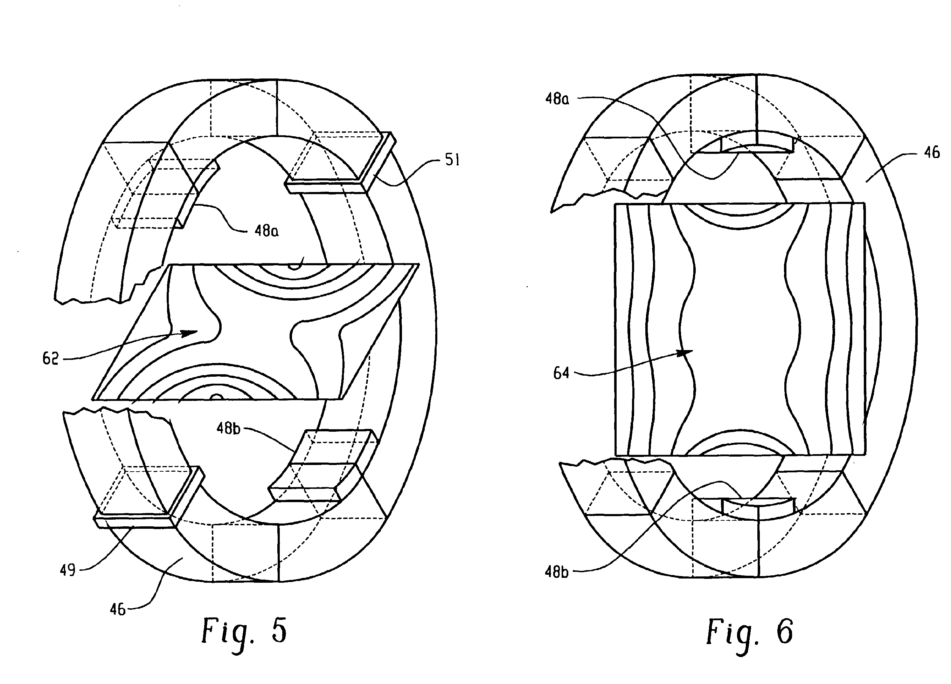

Figure 5 shows the magnetic field strength in the plane perpendicular to that of the yoke and bisecting each of the coils 49 and 51. Figure 5 shows the same strong homogeneous magnetic field within a central portion 62 of this plane, and the low strength field in the path of the ion beam.

Figure 6 shows the magnetic field strength in the plane perpendicular to that of the yoke and bisecting each of the poles 48a and 48b. The profile of the magnetic field in this plane is symmetric along the center axis of the ionization chamber parallel to aperture 18. The strong magnetic field gradients indicate, again, that the magnetic field is of lower strength in the path of the ion beam, which passes through the center of the toroidal yoke.

Thus, by using the inventive magnet assembly 45 of the present invention, including the closed loop yoke 46 and coils 49 and 51, a strong and homogeneous magnetic field is created within the ionization chamber of the ion source, enhancing ionization rates and plasma stability, without adversely affecting beam emittance characteristics. Moreover, the stray magnetic fields generated by the coils 49 and 51 remain oriented in a direction perpendicular to and low within the beam path P2 and do not extend into the area occupied by the extraction electrode 16. In this manner, the beamline optics are not disturbed.

Accordingly, a preferred embodiment of an inventive magnet assembly for an ion source has been described. With the foregoing description in mind, however, it is understood that this description is made only by way of example, that the invention is not limited to the particular embodiments described herein, and that various rearrangements, modifications, and substitutions may be implemented with respect to the foregoing description without departing from the scope of the invention as defined by the following claims and their equivalents.

## Claims

1. An ion source (10) for an ion implanter, comprising:
(i) an ionization chamber (14) defined at least partially by chamber walls (12) and having an aperture (18) through which an ion beam (B) may be extracted along a path (P2); and
(ii) a magnet assembly (45) entirely surrounding said ionization chamber (14), comprising a closed figure yoke (46) about which is wound at least one coil (49, 51).

2. The ion source (10) of claim 1, wherein said at least one coil comprises a pair of coils (49, 51), and wherein said yoke (46) further comprises a pair of opposing poles (48a, 48b), wherein a substantial portion of magnetic flux (F) generated by said coils leaves a first of said opposing poles (48a), passes through the ionization chamber (14), and enters a second of said opposing poles (48b) during operation of the ion source.

3. The ion source (10) of claim 2, wherein said yoke (46) is generally toroidal in shape, said toroidal yoke circumferentially surrounding said ionization chamber (14).

4. The ion source (10) of claim 2, further comprising heat shields (50a, 50b) attached, respectively, to said opposing poles (48a, 48b).

5. The ion source (10) of claim 2, further comprising a non-magnetic shield surrounding said magnet assembly (45) to shield the assembly from backstreaming electrons.

6. The ion source (10) of claim 5, wherein a stray magnetic field output by said magnet assembly (45) is oriented in a direction perpendicular to the path (P2) of an ion beam (B) extracted from said aperture (18).

7. The ion source (10) of claim 6, wherein the magnetic field output by the magnetic assembly (45) is relatively homogeneous within the ionization chamber (14).
